# EUROPEAN PATENT SPECIFICATION

(11) **EP 2 242 867 B1**
(45) Date of publication and mention of the grant of the patent: **20.02.2019**
(21) Application number: 08868953.4
(22) Date of filing: 24.12.2008
(51) Int. Cl.: C23C 14/06, C23C 16/30, G02B 1/10, B82Y 20/00

(54) **A METHOD OF GIVING AN ARTICLE A COLOURED APPEARANCE AND AN ARTICLE HAVING A COLOURED APPEARANCE**
VERFAHREN ZUM VERSEHEN EINES GEGENSTANDS MIT EINEM FARBIGEN AUSSEHEN UND GEGENSTAND MIT FARBIGEM AUSSEHEN
PROCÉDÉ DONNANT À UN ARTICLE UNE APPARENCE COLORÉE ET ARTICLE AYANT UNE APPARENCE COLORÉE

(30) Priority: 28.12.2007 GB 0725259
(43) Date of publication of application: 27.10.2010
(73) Proprietor: IHI Hauzer Techno Coating B.V., 5928 LL Venlo (NL)
(72) Inventor: PEETERS, Paul, NL-5615 NC Eindhoven (NL)
(74) Representative: Manitz Finsterwald Patentanwälte PartmbB
(86) International application number: PCT/EP2008/011117
(87) International publication number: WO 2009/083245

(56) References cited:
- WO-A-2008/024342
- US-A- 5 976 678
- US-A1- 2003 174 384
- MARUYAMA O ET AL: "Non-linear optical properties of titanium dioxide films containing dispersed gold particles" JOURNAL OF NON-CRYSTALLINE SOLIDS, NORTH-HOLLAND PHYSICS PUBLISHING. AMSTERDAM, NL, vol. 259, no. 1-3, 2 November 1999 (1999-11-02), pages 100-106, XP004364375 ISSN: 0022-3093
- MANDAL S K ET AL: "Surface plasmon resonance in nanocrystalline silver particles embedded in SiO2 matrix" JOURNAL OF PHYSICS D (APPLIED PHYSICS) IOP PUBLISHING UK, vol. 35, no. 17, 7 September 2002 (2002-09-07), pages 2198-2205, XP002549440 ISSN: 0022-3727

## Description

The present invention relates to a method of giving an article a coloured appearance and to an article having a coloured appearance.

Methods of giving articles a coloured appearance are well known. For example articles are frequently painted to endow them, with a specific colour. The coloured paint that is used is frequently comprised of colour giving pigments dispersed in a binder such as a resin binder, e.g. paints that are used to finish the bodies of motor cars. Sometimes the paint provides a coloured but matt finish and a transparent top coat is then used to convert the matt colour to a glossy finish. Such paints are again frequently used for motor car bodies. Fabrics are generally coloured by dispersing a pigment throughout the filaments, fibres or yarns used to weave the fabric or by the use of dyes to colour the filaments, fibres or yarns.

The concept of colour as viewed by an observer essentially means, with regard to a non-self luminous article, that the article is illuminated by visible light, typically visible light having wavelengths extending over a wide range of the optical spectrum, which extends from about 380nm (blue end) to 700nm (red end), with the article or its painted (coloured) surface absorbing some wavelengths but reflecting or scattering others. It is the reflected or scattered light which determines the colour of the article as perceived by the viewer.

Some metals, typically aluminium can be given a coloured appearance by anodizing them. Such anodized surfaces also have the advantage that the surface finish is very hard and does not therefore wear easily. Although paints can provide a relatively tough surface such surfaces are prone to wear in use.

Another way of giving articles a coloured appearance is to plate them, e.g. with gold. However, the gold is relatively soft and there is a significant danger that the gold plating will be worn away in use. To overcome this problem it is known to coat the article with a TiN coating by a PVD (physical vapour deposition) process and then to coat it with a thin layer of gold. The TiN coating can be matched very closely to the colour of the gold, so that, if the gold wears away locally the hard TiN coating is reached but does not reveal the fact that the gold has worn away because it has the same colour. Moreover, the TiN coating is very hard so that it is very resistant to wear.

It is also known to coat architectural furniture such as door handles with coatings deposited using a PVD process, so that the corresponding articles are coloured and resistant to wear. Typical colours produced in this way are silver, gold, brown and black.

Another example of coloured articles are stained glass windows. Such windows were already in use in the Middle Ages and it is now known that these were often fabricated by incorporating metallic nanoparticles which give rise to so called surface plasmon resonance in the presence of illuminating light in the optical wavelength range, even if this was not appreciated at the time. This is described in a lecture number 18 apparently given in spring of 2007 at the Oregon State University with the title "Free electron metals: magnetic and optical response" which also describes that such plasmon resonant nanoparticles can be used as biomarkers.

A further example of an article having a coating deposited thereon is disclosed in US 2003/ 174384 A1.

Further background art can be found in the documents WO 2008/024342, US5976678, the publication by Maruyama O et al. "Nonlinear optical properties of titanium dioxide films containing dispersed gold particles", JOURNAL OF NON-CRYSTALLINE SOLIDS, NORTH-HOLLAND PHYSICS PUBLISHING. AMSTERDAM, NL, (19991102), vol. 259, no. 1-3, ISSN 0022-3093, pages 100 - 106, and the publication by Mandal S. K. et al. "Surface plasmon resonance in nanocrystalline silver particles embedded in SiO2 matrix", JOURNAL OF PHYSICS D (APPLIED PHYSICS) IOP PUBLISHING UK, (20020907), vol. 35, no. 17, ISSN 0022-3727, pages 2198 - 2205.

The object of the present invention is to provide a method of giving an article a coloured appearance and an article having a coloured appearance in a new way with the coloured appearance being highly durable and also to provide novel apparatus for carrying out the method and for giving an article a coloured appearance.

Another object of the present invention is to obtain uniform colours without a significant loss of brightness.

In order to satisfy these objects there is provided a method of giving an article a coloured appearance on at least one external surface thereof when illuminated by non-coherent light being one of daylight and light from lighting systems emulating daylight and having wavelengths in the range of 380 to 700nm, the method comprising the following steps:
- depositing a transparent coating on said external surface by use of a PVD (physical vapour deposition) process or of a CVD (chemical vapour deposition process), wherein the transparent coating is selected from the group comprising SiO, SiCO, SiN, C, Al₂O₃, TiO₂, Cr₂O₃, SiOₓ and combinations thereof, and
- incorporating a plurality of dispersed particles within the transparent coating, said particles being selected to generate a selectable colour or hue by surface plasmon resonance, wherein said particles consist of at least one of gold, silver, copper, platinum titanium and chromium,
- wherein the article is provided with a mirror finish at the external surface or coated at said external surface with a coloured layer or a reflective layer or a wavelength selective layer prior to deposition of said transparent coating,
- wherein said transparent coating is given a thickness which is either less than 50nm or greater than half of the coherence length λ_{c} to suppress interference effects arising from interference of the illuminating light reflected at the free surface of said coating with illuminating light reflected at an interface of the coating with the article or with another layer of the coatingor a thickness selected to enhance constructive interference effects for a specific colour and wherein said particles are incorporated in said coating using a PVD or CVD process..

Thus the present invention also exploits the phenomenon of surface plasmon resonance but does so not with transparent articles such as panes of stained glass but with a transparent coating on an otherwise opaque or reflecting article.

The step of depositing a transparent coating thus comprises the use of a PVD (physical vapour deposition) process or of a CVD (chemical vapour deposition process). Such processes enable the thickness of the transparent layer that is deposited to be carefully controlled and kept relatively thin so that the material requirement is minimised.

The transparent coating is selected from the group comprising SiO, SiCO, SiN, C, Al₂O₃, TiO₂, Cr₂O₃, SiOₓ and combinations thereof. Such coatings are typically hard and wear resistant and lend themselves to deposition by PVD and CVD processes such as reactive sputtering and plasma enhanced CVD. Accordingly, articles coated with such a transparent layer have a very tough and durable coating.

The said particles consist of at least one of gold, silver, copper, platinum, titanium and chromium and it is very favourable that these particles are deposited by a PVD process, so that the deposition of the transparent coating and the particles can be carried out in one plant, typically a PVD sputtering plant or a combined PVD/CVD plant. Thus the particles can be incorporated in the transparent coating using a PVD or CVD process.

The thickness of said transparent coating is selected to suppress interference effects arising from interference of the illuminating light reflected at the free surface of said coating with illuminating light reflected at an interface of the coating with the article or with another layer of the coating. This prevents such interference effects detracting from the vibrant coloured appearance of the article.

Such interference suppression can be achieved in different ways. In one variant of the invention the transparent coating is given a thickness significantly smaller than the wavelength of the illuminating light. This means that the thickness of the coating is selected so that the phase difference between the illuminating light reflected at the free surface of said coating and the illuminating light reflected at an interface of the coating with the article is kept to a value sufficiently small that interference cannot arise. Bearing in mind that the illuminating light preferably has a wavelength in the optical range from 380 to 700nm and can cover this range, which is typical for daylight and for some lighting systems that try to emulate daylight, this means that a coating having a thickness of say less that 50nm for example should not generate any interference.

In another variant of the invention said transparent coating is given a thickness greater than the coherence length λ_{C} of the illuminating light. For light sources the concept of the coherence length refers to the length of each wave packet having a number of waves with the same phase position. The illuminating light will comprise a large number of such wave packets; however, with a non-coherent light source such as a fluorescent lamp, there is a completely random association between the waves of individual wave packets so that no discrete interference minima and maxima can arise. Although the waves of a wave packet can interfere with one another, for example giving rise to phenomena such as Newton's rings, if the coating is made with a thickness greater than λ_{C}/2, then the waves of any one packet cannot interfere with other waves of the same packet and again no interference can arise. That is to say the thickness of the coating can be selected in accordance with the invention to ensure that the light reflected at the coating surface and the light reflected from the substrate surface are incoherent. Since the coherence length λ_{C} for many light sources is rather short only small thicknesses of the transparent coating are required to prevent interference arising as described above. Interference within the transparent coating can however be exploited to improve the coloured appearance of an article. E.g. if the transparent coating is given a thickness having a nominal value in the range 80 to 120nm especially of around 100nm it can act to enhance a blue colour by constructive interference (also depending on the refractive index of the transparent coating).

In accordance with the invention the particles can be dispersed in said transparent coating substantially throughout the transparent coating, in particular with a substantially uniform density. If this technique is adopted the density of the dispensed particles within the transparent coating in terms of the number of particles per unit volume of transparent material should be kept relatively low to avoid too much attenuation of the incident illuminating light, which would otherwise tend to be lost in the transparent coating.

Alternatively, and also in accordance with the present invention, the particles can be dispersed in said transparent coating in a stratum thereof and can then have a relatively higher density in terms of the number of particles per unit volume of transparent material.

In one variant of the invention the transparent coating comprises at least first and second layers and said stratum comprises one of said layers, said first and second layers preferably having identical refractive indices.

The article may also be coated, in accordance with the invention, with a coloured layer or a reflective layer or a wavelength selective layer prior to deposition of said transparent coating. E.g. the coloured layer or reflective layer or wavelength selective layer could comprise one of gold, titanium nitride, and zirconium carbonitride. A gold layer for example tends to absorb light at the blue end of the spectrum and to reflect light at the red end of the spectrum. Thus if the article is illuminated with white light, for example with daylight, then the blue end of the spectrum is filtered out and absorbed whereas surface plasmon resonance from the particles dispersed in the coating can be selected to generate a red colour. This red colour is then perceived to be more intense or vivid because the (unwanted) blue part of the spectrum of the illuminating light has been absorbed.

Other techniques can also be used in accordance with the invention to enhance the coloured appearance of the article. Thus, a further material can be incorporated into the transparent coating to modify the refractive index thereof.

The use of the methods outlined above lead to articles having a coloured appearance on at least one external surface thereof when illuminated by light.

Such an article has a coloured appearance on at least one external surface thereof when illuminated by non-coherent light being one of daylight and light from lighting systems emulating daylight and having wavelengths in the range of 380 to 700nm, the coloured appearance being generated by a transparent coating deposited on said external surface by use of a PVD (physical vapour deposition) coating or a CVD (chemical vapour deposition process) coating and a plurality of dispersed particles within the transparent coating, said particles being selected to generate a selectable colour or hue by surface plasmon resonance, wherein the transparent coating comprises one of SiO, SiCO, SiN, C, Al₂O₃, TiO₂, Cr₂O₃, SiOₓ and combinations thereof, wherein said particles consist of at least one of gold, silver, copper, platinum, titanium and chromium, wherein the article is provided with a mirror finish at the external surface or coated at said external surface with a coloured layer or a reflective layer or a wavelength selective layer prior to deposition of said transparent coating and wherein said transparent coating is given a thickness less than 50nm or greater than half of the coherence length λ_{c}, to suppress interference effects arising from interference of the illuminating light reflected at the free surface of said coating with illuminating light reflected at an interface of the coating with the article or with another layer of the coating or is given a thickness selected to enhance interference effects for a specific colour and wherein said particles are incorporated in said coating using a PVD or CVD process.

The present invention will now be explained in more detail with reference to examples and to the accompanying drawings in which are shown:
- Fig. 1: a diagram to illustrate the mechanisms by which the coloured appearance of an article arises due to interference and surface plasmon resonance,
- Fig. 2: another diagram relating to an explanation of a possible way of suppressing the colour produced by interference, in accordance with the present invention,
- Fig. 3: a diagram showing a preferred way of avoiding the coloured effects due to interference,
- Fig. 4: a diagram similar to Fig. 3 but showing the additional use of a reflective coating,
- Fig. 5: a graph showing the reflectivity of light by a gold coating and
- Fig. 6: a diagram illustrating a plant for the generation of coatings on articles to give these a coloured appearance when illuminated with light.

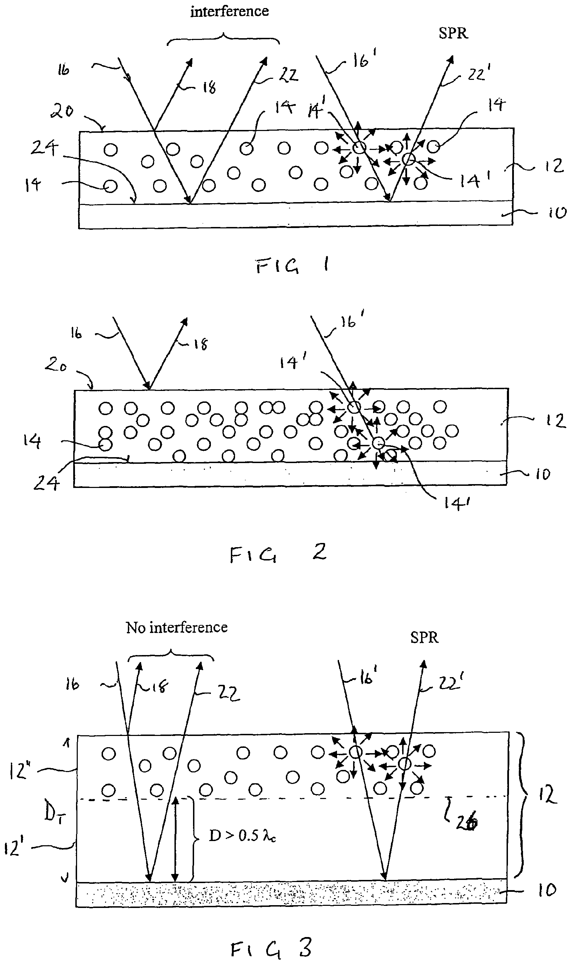

Turning now to Fig. 1 there can be seen an article or substrate 10 having a transparent coating thereon and dispersed within the transparent coating a plurality of metal particles 14. As shown at the left of the drawing the reference numeral 16 relates to an incident ray of visible light and it can be seen that some of the incident light, ray 18 is reflected at the free surface 20 of the transparent coating 12 and some of the incident light, ray 22, is reflected at the interface 24 between the transparent coating and the substrate. The light of ray 18 and that of ray 22 can interfere and such interference will produce the well known interference colours.

At the right of the drawing another incident ray of light 16' is shown which is simply reflected from the mirror finish of the substrate and passes back through the thin film, the transparent coating 12, once more before emerging from the transparent coating as ray 22'. In passing through the transparent coating the light 16' will interact with the conductive metal particles such as 14' embedded in the dielectric forming the transparent coating and will trigger the generation of surface plasmon resonances with a specific colour or hue (range of wavelengths) typical for the metal involved and dependent on the size of the independent discrete particles 14'. The light resulting from surface plasmon resonance is illustrated by the small arrows radiating in all directions from the two particles 14' in Fig. 1. Of course the ray 16' will also trigger a reflection at the surface 20 and the ray 16 could generate surface plasmon resonance if it strikes a particle such as 14. However, these last two possibilities have not been drawn in in Fig. 1 for the sake of clarity.

Turning now to the goal of obtaining uniform colours based on the surface plasmon resonance (SPR) effect in the reflection mode without loss of brightness the following remarks should be made.

Normally SPR based colours can be encountered for instance in old windows in churches. In that case the light is observed in the transmission mode. In contrast the present invention relates to colour generation by SPR in a reflectance mode in a thin film. When a thin film of such a SPR based colour is deposited on a reflecting surface, the colour might be quite different. This is due to the occurrence of two different physical effects.

First of all colour will be produced by the SPR effect as illustrated at the right of the drawing in Fig. 1 Transmitted light is simply reflected from the mirror substrate and passes the thin film once more. For a perfect mirror this would mean that the reflected light will have the same properties as if it had been transmitted through a coating of twice the thickness.

Due to the reflection at the mirror substrate part of the light will interfere with light reflected from the coating surface. This will produce the well known interference colours and will detract from the desired uniform colour or hue resulting from the SPR effect. Due to non-uniformities in the thickness of the transparent coating the interference which occurs represents a loss of colour uniformity, which is again generally undesirable.

One way to prevent the colour produced by interference would be to increase the particle density in the coating. The drawback will be that the brightness of the sample, i.e. the perceived brightness of the article, will most likely decrease significantly, since observed light is now only coming from the scattered light of the particles in the coating plus some contribution from the light reflected at the free surface of the coating. There will also be a tendency for light to be lost in the coating by absorption following scattering at the large number of particles which will again reduce the perceived brightness of the colour.

This situation is illustrated in Fig. 2 in which the same reference numerals are used as in Fig. 1 and have the same significance.

Thus it would be preferable to find another way of avoiding the occurrence of interference colours. One way of doing this is to make certain that the light reflected at the coating surface and the light reflected from the substrate surface are incoherent. One route for achieving this is to start with a thick transparent dielectric layer or coating 12. The thickness of this layer should at least be larger than half the coherence length λ_{C} of the illuminating light that is used. This situation is illustrated in Fig. 3. In Fig. 3 the total thickness D_{T} is greater than the value of λ_{C}/2 this means there can be no interference between the light of ray 18 and that of ray 22 and thus no interference colours. Moreover, the incident light does contribute to the brightness of the perceived appearance of the colour generated by SPR as illustrated at the right of the drawing.

Another way of achieving the same result, i.e. the avoidance of interference colours is to make the coating sufficiently thin that the phase difference introduced by the coating is not sufficient to produce interference. In this connection attention must also be paid to the 180° phase change, i.e. a phase change equal to λ/2 that takes place when light is reflected at an interface between air and a transparent medium, i.e. at the interface 20 in the Figures 1 to 4. This means that the thickness of the coating should not introduce a further phase change of 0, λ, 2λ, 3λ, etc, whereas further phase changes of λ/2, 3λ/2, 5λ/2 etc could be considered. A phase change of 0 would arise for a very thin coating with a thickness very much smaller than the wavelength of the light and this must be related to the lowest wavelength of the illuminating light, for example 400 nm. Here a coating thickness of say 50nm would produce a phase change of ((2 x 50)/400) x 360°, i.e. of 90° so that the total phase change is 90° + 180° = 270°, which would not lead to pronounced interference. A phase change of λ/2 would suggest an ideal coating thickness for blue light of 400/2 = 200nm and this would produce significant enhancement at the blue end of the spectrum and would not be significantly detrimental in the sense of producing interference colours at the red end of the spectrum, because this thickness would correspond to a phase change of (400/700 x 360)° + 180° = 386° and this would not lead to serious interference problems.

If a phase change of 3λ/2 is considered, then for blue light at 400nm the coating thickness would be 3 x 400/2 x 2 = 300nm. For red light at 700nm this same coating thickness would however lead to a phase change of 600/700 x 360°, i.e. of about 309° and, bearing in mind the 180° phase shift at the air/coating interface 20 this is already a critical value so far as interference at the red end of the spectrum is concerned. Higher values such as 5λ/2 or 7λ/2 are clearly no longer feasible, instead one then has to consider a total coating thicknesses of greater than λ_{C}/2 as explained above.

Fig. 3 also shows that the transparent coating 12 could be made in two layers 12' and 12" with the particles only being disposed in the upper layer or stratum 12" (although they could equally be disposed in the lower layer or stratum 12"). The layers 12' and 12" could be of the same transparent dielectric in which case the interface between them shown by the reference numeral 26 is not apparent, because the layers have the same refractive index. The layers could also be deposited continuously with the particles only being deposited in one stratum of the single continuous layer. It is also possible for the particles to be deposited throughout the thick layer 12, but they would then have to have a lower particle density, i.e. number of particles per unit volume, than if they are concentrated in the upper or lower stratum 12" or 12' (or in a middle stratum which would also be possible. The layers 12' and 12" could also be distinct layers, i.e. of different materials, in which case the different materials should have the same refractive index, because otherwise the interface 26 between the layers would give rise to reflection and possibly also to interference.

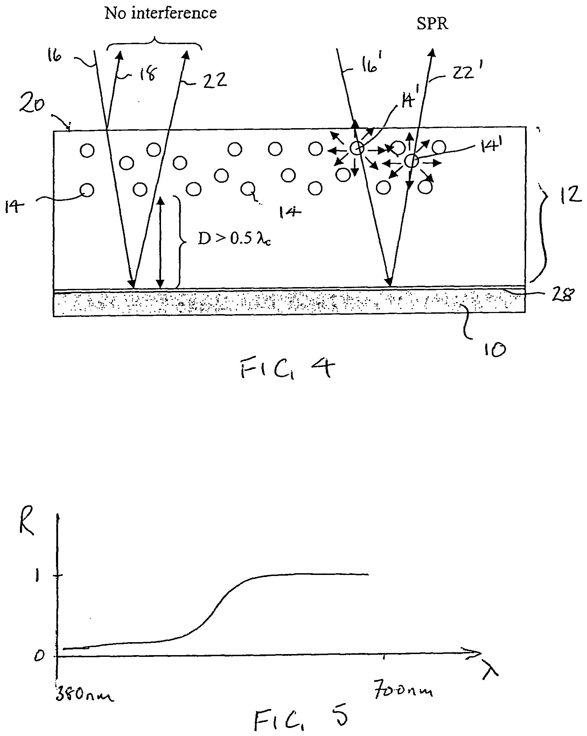

Turning now to Fig. 4 there can be seen a diagram very similar to Fig. 3 but with the difference that a reflective layer 28 is provided on the article beneath the transparent coating 12. The point of the reflective layer is to absorb some of the spectrum of the incident light, and to reflect another part of the spectrum of the incident light thus enhancing the desired apparent colour or hue of the article. In this connection reference can be made to Fig. 5 which shows the reflectivity of a gold coating as a function of the optical wavelength. It can be seen that the gold coating absorbs light at the blue end of the spectrum but reflects light at the red end of the spectrum. Thus a gold base layer can enhance colours or hues in the yellow to red end of the spectrum. The same effect can, for example, be achieved with a TiN or ZrCN coating. Other coatings are conceivable which tend to absorb light at the red end of the spectrum but reflect light at the blue end of the spectrum, for example a TiAlₓN_{y} or ZrAlₓN_{y} coating.

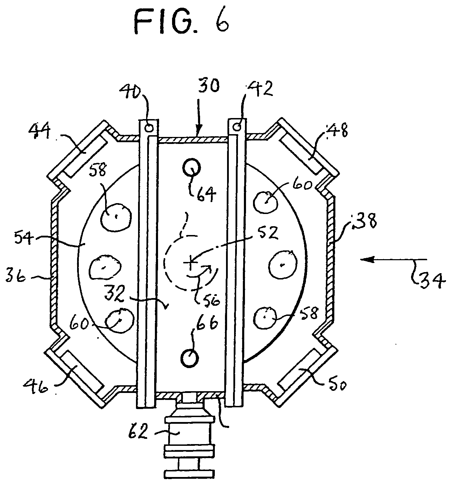

An apparatus for the deposition of such coatings will now be explained with reference to Fig. 6. Fig. 6 shows a schematic drawing of a PVD-coating apparatus which is constructed in accordance with the European patent 0 439 561.

In the form shown in Fig. 6 the treatment chamber 30 has a central at least substantially rectangular housing part 32 when viewed from the side, i.e. in the direction of the arrow 34. Two chamber doors 36, 38 are pivotally connected to the left and right hand sides of the central housing part 32 about vertical pivot axles 40, 42, i.e. axles which stand perpendicular to the plane of the drawing. The chamber doors 36 38 are shaped so that the closed housing has an essentially octagonal shape well known per se. Such treatment chambers and the associated sputtering sources are available from the present applicants. When the doors are closed the chamber is closed off at the top and the bottom by roof and base portions of the doors which are not shown in Fig. 6 for the sake of clarity. The doors can be opened to permit access to the interior of the chamber. Each of the chamber doors 36, 38 includes two targets 44, 46 and 48, 50 respectively so there are four targets in total. Two of the targets, e.g. targets 44 and 48 could, for example, consist of aluminium and the other two 46, 50 of gold and silver respectively. All targets can be magnetron sputtering targets and can be operated with the associated power supplies and magnet systems (not shown here but well known per se).

Each target 44, 46, 48, 50 faces towards the axis of rotation 52 of a suitable rotatable table 54 which is rotatable about the axis of rotation in the direction of the arrow 56. The table carries a plurality of workpiece carriers 58 which are each rotatable about their own axes 60 and which each carry a plurality of workpieces (not shown). Rotation of the workpieces in this way, i.e. about the axes of rotation 60 of the workpiece carriers 58 and about the axis of rotation 52 of the table 54, means that all surfaces of the workpieces can be exposed to the coating flux from the targets and the workpieces can be substantially uniformly coated. It is also possible to use more complicated rotations if necessary or to restrict the movement of the workpieces, for example to a simple rotation about the axis 52 of the table 54 so that only one surface or surface region of the workpiece is coated.

The reference numeral 62 refers to a high performance vacuum pump which serves in known manner to generate the necessary vacuum in the treatment chamber. The reference numeral 64 refers to a supply point for an inert gas, for example argon, while the reference numeral 66 refers to a supply point for a reactive gas such as oxygen.

The plant can be operated as follows:
First of all the atmosphere in the chamber is evacuated and replaced by argon. This is done by in known manner by operation of the vacuum pump 62 and simultaneous supply of argon to flush the originally present residual air from the vacuum chamber. The PVD plant is then operated in a cleaning and etching mode well known per se by operation of the magnetrons with the aluminium targets and using the argon atmosphere to clean and etch the surfaces of the workpieces rather than to coat them. This etching process also leads to a high quality reflective surface at the workpieces.

The apparatus is then changed over to a reactive sputtering mode using the aluminium targets to generate an aluminium vapour and simultaneously supplying oxygen to react with the aluminium vapour and deposit a transparent Al₂O₃ coating on the substrate. This is again well known per se. Assuming a coating in accordance with Fig. 3 is to be deposited the above described sputtering mode is used to first deposit a layer of aluminium oxide without any included gold or silver particles, i.e. the layer12' in Fig. 3. Thereafter one or both of the gold or silver targets, which were hitherto inactive are switched on to deposit small particles of gold or silver in the deposited aluminium oxide coating of layer 12". The deposition of the small particles and the transparent dielectric can be performed either simultaneously or sequentially.

The gold and/or silver targets are operated in such a way, i.e. with operating parameters such as bias voltage, current density and magnetic field, that small agglomerations of gold and/or silver atoms form in the coating, i.e. the desired discrete particles of these metals. The coating is continued until the desired thickness of the coating and the desired particle density of the metal or metals incorporated in the coating have been reached. The workpieces can now be removed from the chamber by opening the chamber doors and will exhibit the required coloured appearance determined by the precise metal or combination of metals selected and the particle sizes of the metal or combination of metals as incorporated in the coating.

It should be noted that with gold and silver there is no significant danger that gold or silver oxides will be deposited instead of the pure metals despite the presence of oxygen in the vacuum chamber. The reason is that the oxides of gold and silver are unstable and revert to the pure metal at temperatures of about 150°C and 250°C respectively. Since the PVD apparatus is or can be operated at higher temperatures the formation of gold or silver oxides is not a problem. The presence of a small quantity of such oxides in the coating is tolerable and large quantities are not in any case expected because of the kinematics of the process and the fact that the oxygen only forms part of the vacuum atmosphere of the chamber.

Platinum also forms an oxide which breaks down at elevated temperature, albeit at a higher temperature than silver. However, the kinematics of the process suggest that a problem with the formation of platinum oxide also does not exist, particularly since the oxygen preferentially reacts with the aluminium. Should a problem with the formation of an oxide exist (or other compound of the metal if a different reactive gas is used) then the coating can be deposited in alternating layers of transparent coating and particles of the metal, with the particles of metal only being deposited when the reactive gas has been flushed from the chamber and replaced by an inert gas. Alternatively a gas frame can be used to supply inert gas to the space between the front face of the target and the surface of the workpieces as they pass in front of the target thus suppressing the formation of metal oxides or other compounds thereof.

If a reflective layer such as 28 in Fig. 4 is to be deposited then this can be done using the gold or silver target operated in a non-reactive mode using an inert gas in the vacuum chamber prior to starting the deposition of the transparent coating.

The step of depositing the transparent coating can also be done by a CVD (chemical vapour deposition process) instead of by a PVD (physical vapour deposition) as described above. Such a CVD process would normally also be carried out in a vacuum chamber containing a plasma generating device or devices for plasma enhanced chemical vapour deposition. The chamber can also include one or more magnetron sources for the deposition of the metals if these cannot be deposited by a CVD process.

The transparent coating can be selected from the group comprising SiO, SiCO, SiN, C, Al₂O₃, TiO₂, Cr₂O₃, SiOₓ and combinations thereof, many of which can be generated by a CVD process or by a sputtering or reactive sputtering process.

The particles used can consist of at least one of gold, silver, copper, platinum and other metals such as titanium or chromium.

## Claims

1. A method of giving an article (10) a coloured appearance on at least one external surface thereof when illuminated by non-coherent light (16) being one of daylight and light from lighting systems emulating daylight and having wavelengths in the range of 380 to 700nm, the method comprising the following steps:
- depositing a transparent coating (12) on said external surface by use of a PVD (physical vapour deposition) process or of a CVD (chemical vapour deposition process), wherein the transparent coating (12) is selected from the group comprising SiO, SiCO, SiN, C, Al₂O₃, TiO₂, Cr₂O₃, SiOₓ and combinations thereof, and
- incorporating a plurality of dispersed particles (14) within the transparent coating, said particles being selected to generate a selectable colour or hue by surface plasmon resonance, wherein said particles (14) consist of at least one of gold, silver, copper, platinum, titanium and chromium,
- wherein the article is provided with a mirror finish at the external surface or coated at said external surface with a coloured layer or a reflective layer (28) or a wavelength selective layer prior to deposition of said transparent coating,
- wherein said transparent coating (12) is given a thickness which is either less than 50nm or greater than half of the coherence length λ_{c} to suppress interference effects arising from interference of the illuminating light (18) reflected at the free surface of said coating with illuminating light (22) reflected at an interface of the coating with the article (10) or with another layer of the coating or a thickness selected to enhance constructive interference effects for a specific colour and wherein said particles are incorporated in said coating using a PVD or CVD process.

2. A method in accordance with any one of the preceding claims, wherein said transparent coating (12) is given a thickness having a nominal value in the range 80 to 120nm especially of around 100nm to enhance a blue colour by constructive interference.

3. A method in accordance with either one of the preceding claims wherein the particles (14) are either dispersed in said transparent coating substantially throughout the transparent coating (12), in particular with a substantially uniform density or are dispersed in said transparent coating (12) in a stratum thereof, said transparent coating comprising at least first and second layers (12, 12') and said stratum comprises one of said layers, said first and second layers (12, 12') preferably having identical refractive indices.

4. A method in accordance with claim 1 wherein said coloured layer, reflective layer (28) or wavelength selective layer comprises one of gold, titanium nitride, and zirconium carbonitride.

5. A method in accordance with any one of the preceding claims and including the step of incorporating a further material into the transparent coating (12) to modify the refractive index thereof.

6. An article (10) having a coloured appearance on at least one external surface thereof when illuminated by non-coherent light (16) being one of daylight and light from lighting systems emulating daylight and having wavelengths in the range of 380 to 700nm, the coloured appearance being generated by a transparent coating (12)deposited on said external surface by use of a PVD (physical vapour deposition) coating or a CVD (chemical vapour deposition process) coating and a plurality of dispersed particles (14) within the transparent coating, said particles being selected to generate a selectable colour or hue by surface plasmon resonance, wherein the transparent coating comprises one of SiO, SiCO, SiN, C, Al₂O₃, TiO₂, Cr₂O₃, SiOₓ and combinations thereof, wherein said particles (14) consist of at least one of gold, silver, copper, platinum, titanium and chromium, wherein the article (10) is provided with a mirror finish at the external surface or coated at said external surface with a coloured layer or a reflective layer (28) or a wavelength selective layer prior to deposition of said transparent coating and wherein said transparent coating (12) is given a thickness less than 50nm or greater than half of the coherence length λ_{c}, to suppress interference effects arising from interference of the illuminating light reflected at the free surface of said coating with illuminating light reflected at an interface of the coating with the article or with another layer of the coating or is given a thickness selected to enhance interference effects for a specific colour and wherein said particles are incorporated in said coating using a PVD or CVD process.

7. An article (10) in accordance with any one of the claims 8 to 10 wherein said transparent coating (12) is given a thickness having a nominal value in the range 80 to 120nm especially of around 100nm to enhance a blue colour by constructive interference.

8. An article (10) in accordance with either one of the preceding claims 6 and 7, wherein the particles (14) are either dispersed in said transparent coating (12) substantially throughout the transparent coating, in particular with a substantially uniform density or are dispersed in said transparent coating in a stratum thereof, said transparent coating comprising at least first and second layers (12, 12') and said stratum comprises one of said layers, said first and second layers preferably having identical refractive indices.

9. An article (10) in accordance with claim 6wherein said coloured layer, or reflective layer (28) or wavelength selective layer comprises one of gold, titanium nitride, and zirconium carbonitride, or any other metal, alloy or metalceramic.

10. An article (10) in accordance with any one of the preceding claims 6 to 9, wherein said transparent coating (12) has a further material homogeneously dispersed therein to modify the refractive index thereof.

11. An article (10) in accordance with any one of the preceding claims 6 to 10, wherein said reflective surface is an etched surface.

## Patentansprüche

1. Verfahren, um einem Gegenstand (10) ein farbiges Aussehen an zumindest einer seiner Außenoberflächen zu verleihen, wenn dieser durch nichtkohärentes Licht (16) beleuchtet wird, das entweder Tageslicht oder Licht von Tageslicht emulierenden Beleuchtungssystemen ist und Wellenlängen im Bereich von 380 bis 700 nm aufweist, wobei das Verfahren die folgenden Schritte umfasst:
- Abscheiden einer transparenten Beschichtung (12) auf der Außenoberfläche unter Verwendung eines PVD-Prozesses (PVD = physikalische Gasphasenabscheidung) oder eines CVD-Prozesses (CVD = chemische Gasphasenabscheidung), wobei die transparente Beschichtung (12) ausgewählt ist aus der Gruppe, umfassend SiO, SiCO, SiN, C, Al₂O₃, TiO₂, Cr₂O₃, SiOₓ und Kombinationen davon, und
- Einarbeiten einer Vielzahl von verteilten Partikeln (14) in die transparente Beschichtung, wobei die Partikel ausgewählt werden, um eine wählbare Farbe oder einen wählbaren Farbton durch Oberflächenplasmonenresonanz zu erzeugen, wobei die Partikel (14) aus zumindest einem von Gold, Silber, Kupfer, Platin, Titan und Chrom bestehen,
- wobei der Gegenstand vor der Abscheidung der transparenten Beschichtung mit einer Hochglanz-Oberflächenbearbeitung an der Außenoberfläche versehen wird oder an der Außenoberfläche mit einer gefärbten Schicht oder einer reflektierenden Schicht (28) oder einer wellenlängenselektiven Schicht beschichtet wird,
- wobei der transparenten Beschichtung (12) eine Dicke verliehen wird, die entweder kleiner als 50 nm oder größer als die Hälfte der Kohärenzlänge λ_{c} ist, um Interferenzeffekte zu unterdrücken, die aus Interferenz des Beleuchtungslichtes (18), das an der freien Oberfläche der Beschichtung reflektiert wird, mit Beleuchtungslicht (22), das an einer Grenzfläche der Beschichtung mit dem Gegenstand (10) oder mit einer anderen Schicht der Beschichtung reflektiert wird, herrührt, oder eine Dicke, die ausgewählt wird, um konstruktive Interferenzeffekte für eine spezifische Farbe zu verstärken, und wobei die Partikel in die Beschichtung unter Verwendung eines PVD- oder CVD-Prozesses eingearbeitet werden.

2. Verfahren nach einem der vorhergehenden Ansprüche, wobei der transparenten Beschichtung (12) eine Dicke mit einem Nennwert im Bereich von 80 bis 120 nm, insbesondere von etwa 100 nm, verliehen wird, um durch konstruktive Interferenz eine blaue Farbe zu verstärken.

3. Verfahren nach einem der vorhergehenden Ansprüche, wobei die Partikel (14) entweder in der transparenten Beschichtung im Wesentlichen durch die gesamte transparente Beschichtung (12) hindurch, insbesondere mit einer im Wesentlichen gleichmäßigen Dichte verteilt werden, oder in der transparenten Beschichtung (12) in einer Lage davon verteilt werden, wobei die transparente Beschichtung zumindest erste und zweite Schichten (12, 12') umfasst und die Lage eine der Schichten umfasst, und die ersten und zweiten Schichten (12, 12') vorzugsweise identische Brechungsindices aufweisen.

4. Verfahren nach Anspruch 1, wobei die gefärbte Schicht, reflektierende Schicht (28) oder wellenlängenselektive Schicht eine von Gold, Titannitrid und Zirconiumcarbonitrid umfassen.

5. Verfahren nach einem der vorhergehenden Ansprüche und das den Schritt eines Einarbeitens eines weiteren Materials in die transparente Beschichtung (12) umfasst, um ihren Brechungsindex zu modifizieren.

6. Gegenstand (10) mit einem farbigen Aussehen an zumindest einer seiner Außenflächen, wenn er mit nichtkohärentem Licht (16) beleuchtet wird, das entweder Tageslicht oder Licht von Tageslicht emulierenden Beleuchtungssystemen ist und Wellenlängen im Bereich von 380 bis 700 nm aufweist, wobei das farbige Aussehen durch eine transparente Beschichtung (12), die auf der Außenoberfläche unter Verwendung einer PVD-Beschichtung (PVD = physikalische Gasphasenabscheidung) oder CVD-Beschichtung (CVD = chemischer Gasphasenabscheidungsprozess) abgeschieden worden ist, und eine Vielzahl von verteilten Partikeln (14) innerhalb der transparenten Beschichtung erzeugt wird, wobei die Partikel ausgewählt sind, um eine wählbare Farbe oder einen wählbaren Farbton durch Oberflächenplasmonenresonanz zu erzeugen, wobei die transparente Beschichtung eine umfasst von SiO, SiCO, SiN, C, Al₂O₃, TiO₂, Cr₂O₃, SiOₓ und Kombinationen davon, wobei die Partikel (14) aus zumindest einem von Gold, Silber, Kupfer, Platin, Titan und Chrom bestehen, wobei der Gegenstand (10) vor der Abscheidung der transparenten Beschichtung mit einer Hochglanz-Oberflächenbearbeitung an der Außenoberfläche versehen worden ist oder an der Außenoberfläche mit einer gefärbten Schicht oder einer reflektierenden Schicht (28) oder einer wellenlängenselektiven Schicht beschichtet worden ist, und wobei der transparenten Beschichtung (12) eine Dicke verliehen ist, die kleiner als 50 nm oder größer als die Hälfte der Kohärenzlänge λ_{c} ist, um Interferenzeffekte zu unterdrücken, die aus Interferenz des Beleuchtungslichtes (18), das an der freien Oberfläche der Beschichtung reflektiert wird, mit Beleuchtungslicht (22), das an einer Grenzfläche der Beschichtung mit dem Gegenstand (10) oder mit einer anderen Schicht der Beschichtung reflektiert wird, herrührt, oder eine Dicke verliehen ist, die ausgewählt ist, um Interferenzeffekte für eine spezifische Farbe zu verstärken, und wobei die Partikel in die Beschichtung unter Verwendung eines PVD- oder CVD-Prozesses eingearbeitet sind.

7. Gegenstand (10) nach einem der Ansprüche 8 bis 10, wobei der transparenten Beschichtung (12) eine Dicke mit einem Nennwert im Bereich von 80 bis 120 nm, insbesondere von etwa 100 nm, verliehen ist, um durch konstruktive Interferenz eine blaue Farbe zu verstärken.

8. Gegenstand (10) nach einem der vorhergehenden Ansprüche 6 und 7, wobei die Partikel (14) entweder in die transparente Beschichtung im Wesentlichen durch die gesamte transparente Beschichtung (12) hindurch, insbesondere mit einer im Wesentlichen gleichmäßigen Dichte verteilt sind, oder in der transparenten Beschichtung (12) in einer Lage davon verteilt sind, wobei die transparente Beschichtung zumindest erste und zweite Schichten (12, 12') umfasst, und die Lage eine der Schichten umfasst, und die ersten und zweiten Schichten (12, 12') vorzugsweise identische Brechungsindices aufweisen.

9. Gegenstand (10) nach Anspruch 6, wobei die gefärbte Schicht oder reflektierende Schicht (28) oder wellenlängenselektive Schicht eines von Gold, Titannitrid und Zirconiumcarbonitrid oder irgendein anderes Metall, eine andere Legierung oder eine andere Metallkeramik umfasst.

10. Gegenstand (10) nach einem der vorhergehenden Ansprüche 6 bis 9, wobei die transparente Beschichtung (12) ein weiteres Material aufweist, das darin homogen verteilt ist, um ihren Brechungsindex zu modifizieren.

11. Gegenstand (10) nach einem der vorhergehenden Ansprüche 6 bis 10, wobei die reflektierende Oberfläche eine geätzte Oberfläche ist.

## Revendications

1. Procédé pour conférer à un article (10) un aspect coloré sur au moins une surface externe de celui-ci lorsqu'il est illuminé par une lumière non cohérente (16) qui est soit la lumière diurne soit la lumière provenant de systèmes d'éclairage émulant la lumière diurne et ayant des longueurs d'onde dans la plage de 380 à 700 nm, le procédé comprenant les étapes suivantes consistant à :
- déposer un revêtement transparent (12) sur ladite surface externe en utilisant un processus PVD (déposition physique en phase vapeur) ou un processus CVD (déposition chimique en phase vapeur), dans lequel le revêtement transparent (12) est sélectionné parmi le groupe comprenant SiO, SiCO, SiN, C, Al₂O₃, TiO₂, Cr₂O₃, SiOₓ, et les combinaisons de ceux-ci, et
- incorporer une pluralité de particules dispersées (14) à l'intérieur du revêtement transparent, lesdites particules étant sélectionnées pour générer une couleur ou une nuance qui peut être sélectionnée par résonance plasmonique de surface, dans lequel lesdites particules (14) sont constituées de l'un au moins des suivants : or, argent, cuivre, platine, titane et chrome,
- dans lequel l'article est doté d'un fini miroir à la surface extérieure ou est revêtu à ladite surface extérieure avec une couche colorée ou une couche réfléchissante (28) ou d'une couche sélective vis-à-vis des longueurs d'onde avant la déposition dudit revêtement transparent,
- dans lequel ledit revêtement transparent (12) a une épaisseur qui est soit inférieure à 50 nm soit supérieure à la moitié de la longueur de cohérence λc pour supprimer des effets d'interférence survenant de l'interférence de la lumière d'illumination (18) réfléchie à la surface libre dudit revêtement avec la lumière d'illumination (22) réfléchie au niveau d'une interface du revêtement avec l'article (10) ou avec une autre couche du revêtement, ou une épaisseur sélectionnée pour renforcer les effets d'interférence constructive pour une couleur spécifique et dans lequel lesdites particules sont incorporées dans ledit revêtement en utilisant un processus PVD ou CVD.

2. Procédé selon l'une quelconque des revendications précédentes,
dans lequel ledit revêtement transparent (12) a une épaisseur ayant une valeur nominale dans la plage de 80 à 120 nm, spécialement autour de 100 nm, pour renforcer une couleur bleue par interférence constructive.

3. Procédé selon l'une ou l'autre des revendications précédentes, dans lequel les particules (14) sont dispersées dans ledit revêtement transparent sensiblement à travers la totalité du revêtement transparent (12), en particulier avec une densité sensiblement uniforme, ou bien sont dispersées dans ledit revêtement transparent (12) dans une strate de celui-ci, ledit revêtement transparent comprenant au moins une première couche et une seconde couche (12, 12'), et ladite strate comprend l'une desdites couches, ladite première couche et ladite seconde couche (12, 12') ayant de préférence des indices de réfraction identiques.

4. Procédé selon la revendication 1, dans lequel ladite couche colorée, ladite couche réfléchissante (28), ou ladite couche sélective vis-à-vis des longueurs d'onde comprend un des éléments suivants : or, nitrure de titane, et carbonitrure de zirconium.

5. Procédé selon l'une quelconque des revendications précédentes, incluant l'étape consistant à incorporer un autre matériau dans le revêtement transparent (12) afin de modifier l'indice de réfraction de celui-ci.

6. Article (10) ayant un aspect coloré sur au moins une surface extérieure de lui-même lorsqu'il est illuminé par une lumière non cohérente (16) qui est soit la lumière diurne soit la lumière provenant d'un système d'éclairage émulant la lumière diurne et ayant des longueurs d'onde dans la plage de 380 à 700 nm, l'aspect coloré étend généré par un revêtement transparent (12) déposé sur ladite surface externe en utilisant un processus de revêtement PVD (déposition physique en phase vapeur) ou un processus de revêtement CVD (déposition chimique en phase vapeur) et une pluralité de particules dispersées (14) à l'intérieur du revêtement transparent, lesdites particules étant sélectionnées pour générer une couleur ou une nuance susceptible d'être sélectionnée par résonance plasmonique de surface, dans lequel le revêtement transparent comprend un composé parmi : SiO, SiCO, SiN, C, Al₂O₃, TiO₂, Cr₂O₃, SiOₓ et des combinaisons de ceux-ci, dans lequel lesdites particules (14) sont constituées de l'un des suivants : or, argent, cuivre, platine, titane et chrome, dans lequel l'article (10) est doté d'un fini miroir à la surface extérieure ou revêtu au niveau de la surface extérieure avec une couche colorée ou une couche réfléchissante (28) ou encore une couche sélective vis-à-vis des longueurs d'onde avant la déposition dudit revêtement transparent, et dans lequel ledit revêtement transparent (12) a une épaisseur inférieure à 50 nm ou supérieure à la moitié de la longueur de cohérence λc, afin de supprimer des effets d'interférence surgissant de l'interférence de la lumière d'illumination réfléchie sur la surface libre dudit revêtement avec la lumière d'illumination réfléchie au niveau d'une interface du revêtement avec l'article ou avec une autre couche du revêtement, ou a une épaisseur sélectionnée pour renforcer les effets d'interférence pour une couleur spécifique, et dans lequel lesdites particules sont incorporées dans ledit revêtement en utilisant un processus PVD ou CVD.

7. Article (10) selon l'une quelconque des revendications 8 à 10, dans lequel ledit revêtement transparent (12) a une épaisseur ayant une valeur nominale dans la plage de 80 à 120 nm, spécialement autour de 100 nm pour renforcer une couleur bleue par interférence constructive.

8. Article (10) selon l'une ou l'autre des revendications précédentes 6 et 7, dans lequel les particules (14) sont dispersées dans ledit revêtement transparent (12) sensiblement à travers tout le revêtement transparent, en particulier avec une densité sensiblement uniforme, ou bien sont dispersées dans ledit revêtement transparent dans une strate de celui-ci, ledit revêtement transparent comprenant au moins une première couche et une seconde couche (12, 12') et ladite strate comprend l'une desdites couches, ladite première couche et ladite deuxième couche ayant de préférence des indices de réfraction identiques.

9. Article (10) selon la revendication 6, dans lequel ladite couche colorée, ou ladite couche réfléchissante (28), ou encore ladite couche sélective vis-à-vis des longueurs d'onde comprend un élément parmi les suivants : or, nitrure de titane, et carbonitrure de zirconium, ou un quelconque autre métal, alliage ou composé métal/céramique.

10. Article (10) selon l'une quelconque des revendications précédentes 6 à 9, dans lequel ledit revêtement transparent (12) comprend un autre matériau dispersé dans celui-ci de façon homogène pour modifier son indice de réfraction.

11. Article (10) selon l'une quelconque des revendications précédentes 6 à 10, dans lequel ladite surface réfléchissante est une surface gravée.
